(19) Europäisches Patentamt
European Patent Office
Office européen des brevets

(11) **EP 2 250 670 B1**

(12) **FASCICULE DE BREVET EUROPEEN**

(45) Date de publication et mention
de la délivrance du brevet:
**24.08.2011 Bulletin 2011/34**

(21) Numéro de dépôt: **09726241.4**

(22) Date de dépôt: **19.02.2009**

(51) Int Cl.:
*H01L 23/485* (2006.01)    *H01L 21/60* (2006.01)

(86) Numéro de dépôt international:
**PCT/FR2009/000185**

(87) Numéro de publication internationale:
**WO 2009/118468 (01.10.2009 Gazette 2009/40)**

(54) **PROCÉDÉ DE CONNEXION ÉLECTRIQUE POUR UN COMPOSANT MUNI D'INSERTS AVEC CALES COMPENSATRICES**

**VERFAHREN ZUR ELEKTRISCHEN VERBINDUNG EINES BAUTEILS MIT EINSÄTZEN MIT AUSGLEICHSBLÖCKEN**

**METHOD FOR THE ELECTRICAL CONNECTION OF A COMPONENT PROVIDED WITH PROTRUSIONS COMPRISING BLOCKS WITH COMPENSATING EFFECT**

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **22.02.2008 FR 0851141**

(43) Date de publication de la demande:
**17.11.2010 Bulletin 2010/46**

(73) Titulaire: **Commissariat à l'Énergie Atomique et aux Énergies Alternatives**
**75015 Paris (FR)**

(72) Inventeurs:
• **SAINT-PATRICE, Damien**
**F-26120 Chabeuil (FR)**
• **MARION, François**
**F-38950 Saint Martin Le Vinoux (FR)**

(74) Mandataire: **Vuillermoz, Bruno et al**
**Cabinet Laurent & Charras**
**"Le Contemporain"**
**50, Chemin de la Bruyère**
**69574 Dardilly Cédex (FR)**

(56) Documents cités:
| WO-A-2006/138491 | FR-A- 2 876 243 |
| JP-A- 5 021 523 | US-A1- 2002 180 029 |
| US-A1- 2005 151 273 | US-B1- 6 406 989 |

**Description**

**DOMAINE DE L'INVENTION**

Le domaine technique auquel se rapporte l'invention est celui de la microélectronique, et plus spécifiquement celui de la fabrication de micro- et nano-structures.

L'invention concerne toute sorte de dispositifs comportant des pointes ou inserts, permettant par exemple leur interconnexion avec d'autres composants électroniques selon des pas réduits.

Plus précisément, la présente invention propose une forme particulière d'inserts, ainsi que des matériaux adaptés à leur réalisation. Ceux-ci permettent, au cours du procédé de connexion ou d'hybridation, de compenser les défauts de planéité lié au parallélisme du dispositif ou à la topographie (topologie) des composants.

**ETAT ANTERIEUR DE LA TECHNIQUE**

Dans le domaine de la connectique utilisant la technique dite « *flip chip*» » ou « puce retournée », la tendance actuelle est à la réduction du « pas », c'est-à-dire de la distance entre les interconnexions reliant puce et substrat.

Dans une telle technique, un substrat porte tous les contacts, sous forme de protubérances ou de protubérances métalliques appelées « *bumps* » qui sont situées sur une seule face. La puce est retournée de telle sorte que les protubérances puissent être soudées à des conducteurs appropriés, positionnés sur cette puce. Cependant, les méthodes d'hybridation conventionnelles, telles la brasure de protubérances, la thermocompression de plots, les ACF (« *Anisotropic Conductive Films* ») ou l'utilisation de polymères conducteurs montrent leurs limites, en termes de réduction du pas.

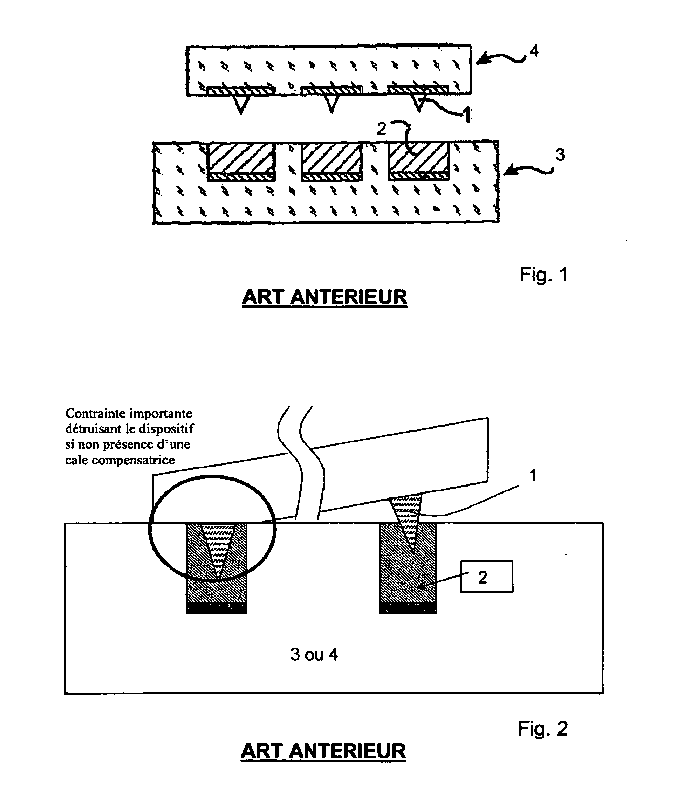

Le document WO2006/054005 propose une interconnexion par insertion d'une pointe conductrice dure dans un caisson ductile. Ce dispositif, illustré à la Figure 1, permet de découpler le maintien mécanique et l'interconnexion électrique. Pour cela, l'interconnexion électrique est réalisée par insertion d'une pointe **1,** réalisée en un matériau dur, dans un caisson enterré **2,** réalisé dans un matériau ductile.

Ce document propose deux façons différentes d'assurer le maintien mécanique de cette structure : par adhésion moléculaire entre les protubérances ou par une couche de colle.

Or, l'adhésion moléculaire entre les protubérances est technologiquement difficile à réaliser, en raison de l'obligation de planéité des surfaces à coller. En effet, le substrat **3** et la puce **4,** pouvant être réalisés dans des matériaux différents dans le cas d'intégration hétérogène, doivent être plans et présentent, comme contrainte supplémentaire, des matériaux différents à l'interface. A titre d'exemple et en rapport avec ce document, le matériau constitutif du substrat 3 est différent du matériau constituant le caisson ductile **2.** De plus, la température d'adhésion moléculaire est généralement élevée et incompatible à l'intégration de structures présentant des coefficients de dilatation thermique différents.

L'autre alternative, à savoir l'adhésion par une couche de colle, est également difficilement réalisable, en raison de l'impossibilité de l'intégrer après hybridation. En effet, il n'y a pas d'espace entre la puce **4** et le substrat **3** pour permettre à la colle de se propager. Par ailleurs, la solution consistant à dispenser de la colle avant l'hybridation n'est pas envisageable car celle-ci serait chassée hors de l'interface en raison de la pression exercée.

En outre, ce type de dispositif ne permet pas de compenser les défauts de parallélisme lors de l'hybridation et les défauts de topologie du « *wafer* ». En effet et comme cela est illustré à la Figure 2, ces défauts créent des pressions locales importantes, endommageant définitivement le composant. Dans le cas de défaut de planéité, des zones de non contact peuvent aussi être créées.

**EXPOSE DE L'INVENTION**

L'invention proposée s'inscrit dans la recherche d'une solution technique permettant, simultanément à la connexion électrique, d'assurer le maintien mécanique et de compenser les défauts de topologie dus à l'étape d'hybridation ou du « *wafer* » lui-même.

Ainsi et selon l'invention, un composant comporte, sur une face, un ensemble d'inserts conducteurs destinés à être connectés électriquement avec des zones enterrées conductrices d'un autre composant.

De manière caractéristique selon l'invention, les inserts reposent sur des cales conductrices positionnées à la surface du composant.

Dans le cadre de l'invention, les composants désignent avantageusement une puce ou un substrat à connecter électriquement et mécaniquement à un autre substrat. En pratique, il peut s'agir de la connexion d'une puce à un « wafer » (tranche) ou d'une connexion wafer/wafer.

Il avait certes été décrit de relier de tels composants à l'aide d'inserts, avantageusement de micro-inserts ou micropointes, à introduire dans des protubérances enterrées ductiles, présentes au niveau du second composant à relier.

Selon l'invention, le dispositif de connexion présente un élément supplémentaire, à savoir une cale, également appelée base ou marche, disposée à la surface du composant, notamment la puce, et sur laquelle l'insert repose.

Cette cale présente comme caractéristique essentielle d'être conductrice. Cela signifie qu'elle est réalisée dans un matériau conducteur, appelé par la suite M5, ou bien dans un matériau isolant, tel un polymère, recouvert d'une couche conductrice.

Une telle cale est également définie par sa hauteur h'.

De manière avantageuse, elle présente une surface supérieure à celle de la surface d'appui de l'insert sur cette cale.

Avantageusement, cette cale conductrice présente, au niveau de sa surface de contact avec l'insert, au moins une dimension supérieure à celle de la zone située en regard de l'insert qu'elle porte. Ainsi, la profondeur de l'enfoncement de l'insert dans la dite protubérance est contrôlée par cette cale qui vient en butée, au moins localement, au niveau de la surface de l'autre composant. Cette cale d'arrêt de hauteur h' permet ainsi de ménager un espace entre les deux composants, utile notamment pour y introduire une couche de colle.

Selon une caractéristique privilégiée, la cale conductrice est réalisée à l'aide d'un matériau déformable (M5).

Dans cette optique et de manière privilégiée, le matériau (M5) de la cale conductrice présente une ductilité supérieure à celle du matériau (M1) constituant l'insert, voire à celle du matériau (M2) constituant la zone dans laquelle est introduit l'insert.

Pour remplir cette dernière condition et à titre d'exemple, l'insert est réalisé en or (Au) et la cale est constituée d'aluminium (Al) ou d'indium (in), ou bien elle est réalisée en polymère recouvert d'un film d'Au.

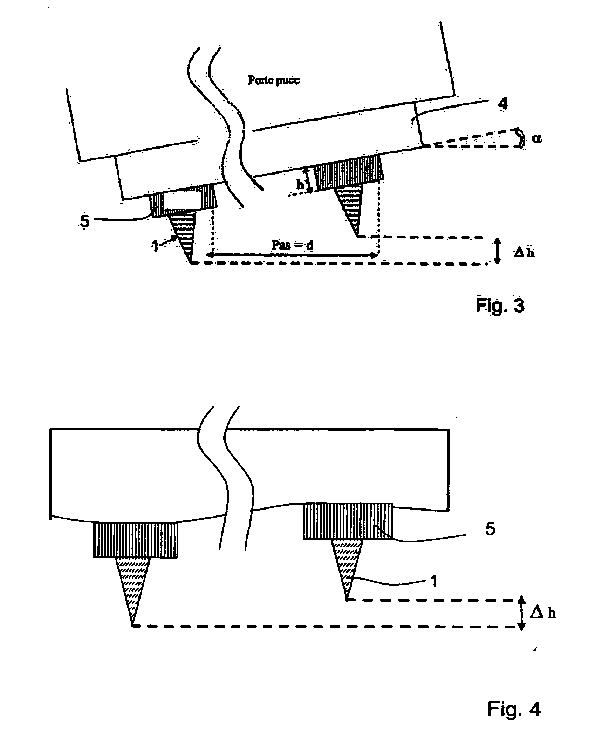

Comme déjà dit, une telle structure permet de rattraper les défauts de planéité, liés soit à la machine (Figure 3), soit au wafer (Figure 4), fréquemment rencontrés dans la thématique d'interconnexion « *flip-chip* » de grande surface. En effet et de par la nature déformable du matériau qui la constitue, la hauteur h' de la cale est susceptible de varier localement, et notamment de diminuer lorsque les contraintes exercées entraînent sa compression.

Selon l'invention, il est donc possible de dimensionner cette cale, en fonction de la topologie des composants à connecter.

La variation de hauteur maximale, notée Δh, est liée à la distance maximale, notée d, des connexions périphériques. Dans le cas d'un assemblage puce/tranche, cette distance est égale à la plus grande dimension de la zone d'interconnexion. Dans le cas d'un assemblage substrat/substrat, cette distance est égale à la plus grande distance entre les connexions périphériques des puces en bord de plaque.

Ainsi, cette variation Δh entre les connexions périphériques séparées d'une distance d, à compenser lors de l'hybridation, est donnée par la formule suivante :

$$\Delta h = \tan(\alpha).d$$

dans laquelle α représente le défaut de parallélisme (Fig. 3)

Pour un défaut de parallélisme α donné, la variation de niveau Δh créant les contraintes à une distance d est tabulée dans le tableau ci-dessous :

| Angle α (mrad) | Δh (μm) pour d=2cm | Δh (μm) pour d=20cm |
|---|---|---|
| 0,001 | 0,02 | 0,20 |
| 0,01 | 0,20 | 2,00 |
| 0,03 | 0,60 | 6,00 |
| 0,05 | 1,00 | 10,00 |
| 0,1 | 2,00 | 20,00 |
| 0,2 | 4,00 | 40,00 |

Dans le cadre de la présente invention et de manière privilégiée, la hauteur h' de la cale est dimensionnée de sorte que la déformation plastique ou élastique du matériau M5 la constituant compense les défauts de planéité, incarnés par la grandeur Δh.

Ainsi, si une déformation inférieure à Y % de la hauteur de la cale h' est recherchée, l'épaisseur de celle-ci (h'), dans le cas d'un défaut de parallélisme, est donnée par la formule suivante:

$$h' \geq \frac{\tan(\alpha).d}{Y/100}$$

Dans le cas d'un défaut lié à la planéité du wafer Δh (Fig. 4), la hauteur h' de la cale, exprimée en fonction de la déformation voulue de Y %, est donnée par la formule :

$$h' \geq \frac{Y}{100}.\Delta h$$

La présente invention concerne donc un procédé de connexion entre deux composants, notamment une puce et un substrat, le premier composant étant doté d'inserts reposant sur une cale, comme décrit ci-dessous, et le second composant étant doté de zones ductiles conductrices enterrées disposées vis-à-vis de ces inserts.

Il s'agit donc d'introduire les inserts dans ces zones jusqu'à ce que la cale des inserts vienne en butée, au moins localement, à la surface de ces zones qui correspond également à la surface du second composant.

Grâce au caractère déformable de cette cale, il est possible de connecter parallèlement les deux composants, même dans le cas d'un défaut de parallélisme dans l'hybridation ou d'une épaisseur non constante du « wafer ».

Selon l'invention et comme déjà dit, la cale conductrice est réalisée en matériau déformable (M5), présentant une ductilité supérieure à celle du matériau (M1) constituant l'insert et à celle du matériau (M2) constituant la zone. Par ailleurs elle présente une hauteur h' bien définie :

Lorsqu'il s'agit d'un défaut de parallélisme dans l'hybridation, la hauteur h' de la cale est définie comme suit :

$$h' \geq \frac{\tan(\alpha).d}{Y/100}$$

dans laquelle :

- $\alpha$ représente le défaut de parallélisme ;
- d représente la distance maximale entre deux inserts (1) ; et
- Y représente la déformation de la cale (5) supportant l'insert (1).

Dans le cas d'une épaisseur non constante du composant, la hauteur h' de la cale est définie comme suit :

$$h' \geq \frac{Y}{100}.\Delta h$$

dans laquelle :

- Δh représente la variation de hauteur maximale entre deux éléments d'interconnexion (5, 1) ; et
- Y représente la déformation de la cale (5) supportant l'insert (1).

Il est à noter qu'il ne s'agit pas nécessairement de deux inserts juxtaposés. De fait, Δh peut donc représenter la variation de hauteur entre deux éléments d'interconnexion quelconques.

Comme déjà dit, le maintien mécanique de cette connexion peut être réalisé au moyen de colle introduite dans l'espace ménagée par les cales des inserts, à l'interface des deux composants.

Le dimensionnement de la cale permet également de prévoir le volume de la colle à introduire pour assurer un bon maintien. Notamment dans le cas particulier d'une hybridation puce sur substrat, le volume de colle est le suivant :

$$Vcolle = 1,1 * (pas^2 - L*l) * h' * N$$

où

- pas désigne le pas répétitif entre deux motifs élémentaires ;
- N désigne le nombre d'éléments d'interconnexion (élément = insert + cale) ;
- h' désigne la hauteur de la cale selon l'invention ;
- L désigne la largeur de la cale selon l'invention ; et
- 1 désigne la longueur de la cale selon l'invention.

Dans cette formule, le facteur 1,1 permet de surévaluer de 10 % le volume minimal à déposer pour obtenir un collage homogène sur toute la puce.

La dispense de colle peut s'effectuer par un dépôt local au centre de la puce ou par centrifugation afin de déposer une hauteur contrôlée.

Ainsi, la présente invention permet de résoudre les insuffisances de l'art antérieur, à savoir la détérioration irréversible de l'interconnexion et du composant lui-même si l'insert n'est pas positionné au dessus d'un matériau déformable, ladite détérioration étant causée par les contraintes locales très importantes liées aux défauts de parallélisme lors de l'étape d'insertion (cf. Figure 2) ou des défauts de planéité.

Comme déjà dit, la présente invention trouve de nombreuses applications, notamment pour l'interconnexion de type *« flip chip »* de matériaux hétérogènes, par exemple pour les imageurs infrarouge de grandes dimensions.

## BREVE DESCRIPTION DES FIGURES

La manière dont l'invention peut être réalisée et les avantages qui en découlent ressortiront mieux de l'exemple de réalisation qui suit, donné à titre indicatif et non limitatif, à l'appui des figures annexées parmi lesquelles :

La figure 1 illustre un système de connexion substrat/puce selon l'art antérieur.

La figure 2 illustre les contraintes s'exerçant au niveau d'un dispositif selon l'art antérieur, dans le cas d'un défaut de parallélisme.

La figure 3 schématise la structure selon le procédé de l'invention permettant de rattraper les défauts de parallélisme à longue distance.

La figure 4 schématise la structure selon le procédé de l'invention permettant de rattraper les défauts de planéité liés à la topologie du wafer.

La figure 5 schématise le procédé de fabrication d'un dispositif selon l'invention.

La figure 6 illustre la déformation de la structure selon le procédé de l'invention rattrapant les défauts de parallélisme et permettant l'intégration d'un film de colle.

La figure 7 illustre la déformation de la structure selon le procédé de l'invention rattrapant les défauts de planéité liés au wafer et permettant l'intégration d'un film de colle.

## MODES DE REALISATION DE L'INVENTION

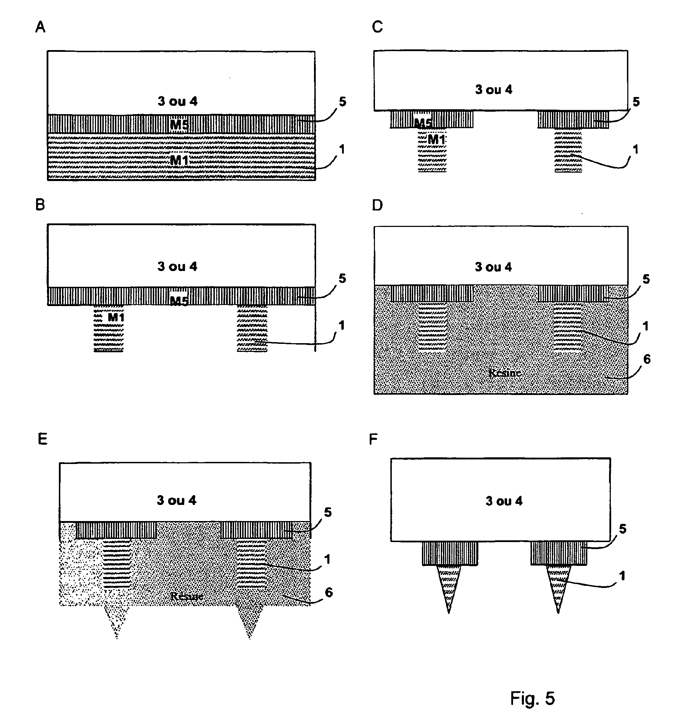

Un dispositif d'interconnexion selon le procédé de l'invention peut être réalisé de la manière suivante, illustrée à la Figure 5 :

- dépôt multicouche des matériaux (M5 et M1, respectivement) constituant la marche **5** et la pointe **1** sur la puce **4** ou le substrat 3 (Figure 5A) ;
- dépôt résine/photo/gravure de la couche en matériau M1 (Figure 5B) ;
- dépôt résine/photo/gravure de la couche en matériau M5 (Figure 5C) ;
- dépôt d'une résine "planarisante" **6** (Figure 5D) ;
- étape d'impression de la résine par un moule et réticulation de la résine en température (Figure 5E), ou aux UV ;
- réplication de la forme de la résine par usinage ionique ou plasma RIE (Figure 5F).

Le document US 2005/191842 décrit la réalisation d'une marche en polyimide, sur laquelle il est envisageable de réaliser des inserts comme décrit ci-dessus.

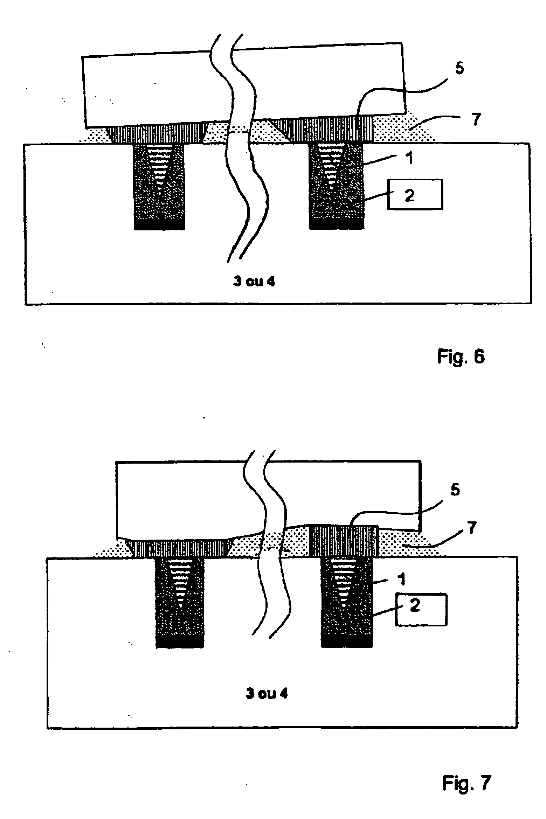

L'insertion de la pointe **1,** montée sur une cale déformable **5,** dans le caisson ductile **2** de l'élément correspondant (puce **4** ou substrat **3)** et le maintien de l'interconnexion au moyen de colle **7** sont illustrées aux figures 6 et 7, dans le cas de défauts de parallélisme et de défauts de planéité liés au wafer, respectivement.

Il ressort clairement de la présente demande qu'un assemblage selon l'invention offre de nombreux avantages en permettant :

- de contrôler le blocage de l'insertion en z grâce à-la marche-ou cale d'arrêt-située en dessous de l'insert ;
- d'augmenter la tolérance sur la pression d'insertion en raison de la déformation de la cale entraînant l'homogénéisation de la pression sur le composant ;
- de compenser les défauts de planéité des surfaces par la déformation de la cale ;
- de gérer le surplus de matière évacuée lors de l'insertion évitant la création de courtcircuit par l'espace vide entre les pointes ;
- de contrôler l'épaisseur entre la puce et le substrat par l'épaisseur de la marche, permettant ainsi l'intégration d'un film de colle uniforme.

**Revendications**

1. Procédé de connexion électrique entre :

   - un premier composant (4) comportant, sur une face, un ensemble d'inserts conducteurs (1) reposant sur des cales conductrices (5) positionnées à la surface du composant (4) ; et
   - un second composant (3) comportant, sur une face, un ensemble de zones enterrées conductrices (2), situées en regard des inserts (1) et présentant au moins une dimension inférieure à celles des cales (5) au niveau de leur surface de contact avec l'insert,
   consistant à introduire chaque insert (1) dans une zone enterrée (2), selon lequel :
   • la cale conductrice (5) est réalisée en matériau déformable (M5), présentant une ductilité supérieure à celle du matériau (M1) constituant l'insert (1) et à celle du matériau (M2) constituant la zone enterrée (2) ; et
   • la cale conductrice (5) présente une hauteur h' qui s'etend entre la surface du composant et la surface sur laquelle l'insert repose, cette hauteur étant définie par la formule suivante :

   $$h' \geq \frac{\tan(\alpha).d}{Y/100}$$

   dans laquelle :

   - α représente le défaut de parallélisme dans l'hybridation entre la face du premier composant portant les inserts et la face en regard du second composant;
   - d représente la distance maximale entre deux inserts (1); et
   - 100 représente le pourcentage voulu pour la déformation de la hauteur de la cale (5) supportant l'insert (1).

   ou par la formule suivante :

   $$h' \geq \frac{Y}{100}.\Delta h$$

   dans laquelle :

   - Δh représente la variation de hauteur maximale entre deux éléments d'interconnexion (5, 1) constitués chacun d'un insert et d'une cale ; et
   - 100 représente le pourcentage voulu pour la déformation de la hauteur de la cale (5) supportant l'insert (1).

2. Procédé de connexion selon la revendication 1, *caractérisé* **en ce que** l'insert (1) est réalisé en or (Au) et **en ce que** la cale (5) est constituée d'aluminium (Al) ou d'indium (In), ou est réalisée en polymère recouvert d'un film d'Au.

3. Procédé de connexion selon l'une des revendications précédentes, *caractérisé* **en ce que** les inserts (1) sont introduits dans les zones (2) jusqu'à que les cales (5) viennent en butée, au moins localement.

4. Procédé de connexion selon l'une des revendications précédentes, *caractérisé* **en ce que** le maintien mécanique entre les deux composants est assuré par un collage à l'interface des deux composants.

5. Procédé de connexion selon la revendication 4, *caractérisé* **en ce que** le volume de colle est déterminé selon la formule suivante :

$$Vcolle = 1,1 * (pas^2 - L*l) * h' * N$$

où :

- pas désigne le pas répétitif entre deux motifs élémentaires constitués par les cales conductrices (s);
- N désigne le nombre d'éléments d'interconnexion (5, 1) ;
- h' désigne la hauteur des cales (5) ;
- L désigne la largeur des cales (5) ;
- 1 désigne la longueur des cales (5).

**Claims**

1. A method for electrical connection between:

- a first component (4) comprising, on one face, a set of conductive inserts (1) resting on conductive blocks (5) positioned at the surface of the component (4); and
- a second component (3) comprising, on one face, a set of conductive buried regions (2), located opposite the inserts (1) and having at least one dimension smaller than that of the blocks (5) in their contact surface with the insert, comprising inserting each insert (1) into one buried region (2), according to which:

  • the conductive block (5) is made out of deformable material (M5), having greater ductility than that of the material (M1) constituting the insert (1) and than that of the material (M2) constituting the buried region (2); and
  • the conductive block (5) has a height h' extending between the surface of the component and the surface onto which the insert lie, this height being defined by the following formula:

$$h' \geq \frac{\tan(\alpha).d}{Y/100}$$

wherein:

- $\alpha$ represents the parallelism defect in the hybridization between the face of the first component onto which is positioned the insert and the opposing face of the second component ;
- d represents the maximum distance between two inserts (1); and
- Y/100 represents the required percentage for deformation of the height of the block (5) supporting the insert (1).

or by the following formula:

$$h' \geq \frac{Y}{100} . \Delta h$$

wherein:

- $\Delta h$ represents the variation in maximum height between two interconnect elements (5, 1) each being constituted by an insert and a block; and
- Y/100 represents the required percentage for the deformation of the height of the block (5) supporting the insert (1).

2. The connection method as claimed in claim 1, *characterized* **in that** the insert (1) is made out of gold (Au) and **in that** the block (5) is composed of aluminium (Al) or indium (In), or is made out of polymer coated with a film of Au.

3. The connection method as claimed in any one of the previous claims, *characterized* **in that** the inserts (1) are inserted into the regions (2) until the blocks (5) are stopped, at least locally.

4. The connection method as claimed in one of the previous claims, *characterized* **in that** mechanical holding between the two components is provided by bonding at the interface of the two components.

5. The connection method as claimed in claim 4, *characterized* **in that** the volume of adhesive is determined in accordance with the following formula:

$$Vadhesive = 1.1 * (pitch^2 - L*l) * h' * N$$

where:

- pitch denotes the repetitive pitch between two elementary patterns constituted by the conductive blocks (1);
- N denotes the number of interconnect elements (5, 1);
- h' denotes the height of the blocks (5);
- L denotes the width of the blocks (5);
- 1 denotes the length of the blocks (5).

**Patentansprüche**

1. Verfahren zur elektrischen Verbindung zwischen :

- einem ersten Bauteil (4), das auf einer Seite eine Anordnung leitender Einsätze (1) besitzt, die sich auf leitenden Ausgleichsblöcken (5) befinden, welche auf der Oberfläche des Bauteils (4) angeordnet sind ; und
- einem zweiten Bauteil (3), das auf einer Seite eine Anordnung eingelassener, leitender Zonen (2) besitzt, die den Einsätzen (1) zugewandt angeordnet sind, und im Bereich ihrer Kontaktoberfläche mit dem Einsatz mindestens eine Abmessung aufweisen, die geringer ist als die der Ausgleichsblöcke (5), das darin besteht, jeden Einsatz (1) in eine eingelassene Zone (2) einzuführen, wobei :
- der leitende Ausgleichsblock (5) aus einem verformbaren Material (M5) hergestellt ist, das eine Duktilität besitzt, die höher ist als die des Materials (M1), aus dem der Einsatz (1) hergestellt ist, und als die des Materials (M2), aus der die eingelassene Zone (2) hergestellt ist; und
- der leitende Ausgleichsblock (5) eine Höhe h' aufweist, die zwischen der Oberfläche des Bauteils und der Oberfläche verläuft, auf der sich der Einsatz befindet, wobei diese Höhe durch die folgende Formel definiert ist:

$$h' \geq \frac{\tan(\alpha).d}{Y/100}$$

in der :

    - a die Abweichung von der Planparallelität in der Hybridisierung zwischen der Seite des ersten Bauteils, an dem sich die Einsätze befinden, und der Seite, die dem zweiten Bauteil zugewandt ist, darstellt ;
    - d den maximalen Abstand zwischen zwei Einsätzen (1) darstellt ; und
    - Y / 100 den gewünschten Prozentsatz für die Verformung der Höhe des Ausgleichsblockes (5), der den Einsatz (1) hält, darstellt.

oder durch die folgende Formel :

$$h' \geq \frac{Y}{100}.\Delta h$$

in der :

    - Δh die Änderung der maximalen Höhe zwischen zwei Verbindungselementen (5, 1), die jeweils aus einem Einsatz und einem Ausgleichsblock bestehen, darstellt ; und
    - Y / 100 den gewünschten Prozentsatz für die Verformung der Höhe des Ausgleichsblockes (5), der den Einsatz (1) hält, darstellt.

**2.** Verbindungsverfahren nach Anspruch 1, *dadurch gekennzeichnet, dass* der Einsatz (1) aus Gold (Au) hergestellt ist, und dass der Ausgleichsblock (5) aus Aluminium (Al) oder aus Indium (In) hergestellt ist, oder aus einem Polymer hergestellt ist, das mit einer dünnen Schicht aus Au überzogen ist.

**3.** Verbindungsverfahren nach einem der vorhergehenden Ansprüche, *dadurch gekennzeichnet, dass* die Einsätze (1) so weit in die Zonen (2) eingeführt sind, bis die Ausgleichsblöcke (5) zumindest lokal anstoßen.

**4.** Verbindungsverfahren nach einem der vorhergehenden Ansprüche, *dadurch gekennzeichnet, dass* der mechanische Halt zwischen den beiden Bauteilen durch Kleben an der Schnittstelle bzw. Übergangsfläche der beiden Bauteile gewährleistet ist.

**5.** Verbindungsverfahren nach Anspruch 4, *dadurch gekennzeichnet, dass* die Menge des Klebstoffes nach der folgenden Formel bestimmt ist :

$$Vcolle = 1,1*(pas^2 - L*l)* h'*N$$

wobei :

    - pas den Wiederholungsschritt zwischen zwei Grundmustern bezeichnet, die aus den leitenden Ausgleichsblöcken (5) bestehen ;
    - N die Anzahl von Verbindungselementen (5, 1) bezeichnet ;
    - h' die Höhe der Ausgleichsblöcke (5) bezeichnet ;

- L die Breite der Ausgleichsblöcke (5) bezeichnet ;
- I die Länge der Ausgleichsblöcke (5) bezeichnet.

EP 2 250 670 B1

**Fig. 1**

**ART ANTERIEUR**

Contrainte importante
détruisant le dispositif
si non présence d'une
cale compensatrice

3 ou 4

**Fig. 2**

**ART ANTERIEUR**

11

Fig. 3

Fig. 4

A

3 ou 4

M5 — 5

M1 — 1

B

3 ou 4

M5 — 5

M1

— 1

C

3 ou 4

M5 — 5

M1

— 1

D

3 ou 4

— 5

— 1

Résine — 6

E

3 ou 4

— 5

— 1

Résine — 6

F

3 ou 4

— 5

— 1

Fig. 5

Fig. 6

Fig. 7

**EP 2 250 670 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2006054005 A
- US 2005191842 A